# EUROPÄISCHE PATENTSCHRIFT

(11) **EP 0 854 209 B1**
(45) Veröffentlichungstag und Bekanntmachung des Hinweises auf die Patenterteilung: **09.02.2000**
(21) Anmeldenummer: 97121840.9
(22) Anmeldetag: 11.12.1997
(51) Int. Cl.: C30B 15/14, C30B 15/30

(54) **Verfahren zur Herstellung eines Silicium-Einkristalls und Heizvorrichtung zur Durchführung des Verfahrens**
Process to produce silicon single crystal and heating apparatus for this process
Procédé de préparation d'un monocristal de silicium et dispositif de chauffage pour la mise en oeuvre de ce procédé

(30) Priorität: 17.12.1996 DE 19652543
(43) Veröffentlichungstag der Anmeldung: 22.07.1998
(73) Patentinhaber: Wacker Siltronic Gesellschaft für Halbleitermaterialien Aktiengesellschaft, 84489 Burghausen (DE)
(72) Erfinder: von Ammon, Wilfried, Dr., 84489 Burghausen (DE); Tomzig, Erich, Dr., 84508 Burgkirchen (DE); Fuchs, Paul, 5231 Schalchen (AT); Gelfgat, Yuri, Prof., Riga 1010 (LV)
(74) Vertreter: Rimböck, Karl-Heinz, Dr.

(56) Entgegenhaltungen:
- EP-A- 0 628 645
- DE-B- 1 289 515
- DE-B- 1 289 519
- FR-A- 1 515 916
- US-A- 5 162 072
- US-A- 5 360 599
- PATENT ABSTRACTS OF JAPAN vol. 8, no. 241 (C-250) [1678] , 6.November 1984 & JP 59 121183 A (FUJITSU KK)
- GIESS ET AL.: "combination heater-magnetic solenoid coils for suppressing melt convection in crystal growth" IBM TECHNICAL DISCLOSURE BULLETIN, Bd. 26, Nr. 9, Februar 1984, NEW YORK US, Seite 4716 XP002054780

## Beschreibung

Gegenstand der Erfindung ist ein Verfahren zur Herstellung eines Silicium-Einkristalls nach der Czochralski-Methode. Gegenstand der Erfindung ist ferner eine Heizvorrichtung zum Beheizen eines mit Silicium gefüllten Tiegels, die unterhalb des Tiegels angeordnet ist.

Bei der Herstellung von Silicium-Einkristallen nach der Czochralski-Methode wird festes Silicium in einem Quarzglas-Tiegel, nachfolgend auch nur als Tiegel bezeichnet, aufgeschmolzen. Danach wird ein Impfkristall in die Schmelze getaucht und ein Einkristall aus der Schmelze gezogen. Die Methode wurde seit ihren Anfängen stetig fortentwickelt, und man ist gegenwärtig in der Lage, Einkristalle mit Durchmessern von mehr als 200 mm zu ziehen. Allerdings bereitet die Herstellung von großen Einkristallen eine Reihe von Problemen. Eines dieser Probleme betrifft die Temperatur- und Strömungsverhältnisse beim Aufschmelzen des Siliciums und beim Ziehen des Einkristalls. Man ist daran interessiert, das Silicium möglichst schnell aufzuschmelzen und Temperatur- und Strömungsverhältnisse in der Schmelze zu schaffen, die zum versetzungsfreien Ziehen des Einkristalls notwendig sind. Zur Herstellung von großen Einkristallen müssen entsprechend große Volumina von Silicium im Tiegel geschmolzen werden. In der Regel werden polykristalline Bruchstücke verwendet oder versetzungsbehaftete Einkristalle, die zurückgeschmolzen werden müssen. Die zum Aufschmelzen notwendige Heizenergie stammt üblicherweise von Widerstandsheizelementen, die seitlich um den Tiegel herum und unter dem Tiegel angeordnet sind. Eine Vorrichtung mit solchen Heizelementen ist beispielsweise in der US-5,360,599 offenbart. Dem raschen Aufschmelzen des Siliciums durch Aufheizen der Heizelemente auf Temperaturen, die weit über dem Schmelzpunkt des Siliciums liegen steht entgegen, daß der Tiegel von flüssigem Silicium angegriffen wird, wenn die Tiegelwand überhitzt wird. Es besteht die Gefahr, daß Partikel aus dem Tiegelmaterial herausgelöst werden und während des Ziehens des Einkristalls zur Kristallisationsgrenze gelangen und Versetzungen herbeiführen. Ein übermäßiger Temperaturgradient zwischen der Tiegelwand und der Kristallisationsgrenze erzeugt darüber hinaus unkontrollierte Konvektionsströme, die wiederum zu unerwünschten lokalen Schwankungen der Temperatur der Schmelze und der Konzentration von Dotierstoff und Verunreinigungen in der Schmelze führen.

In der FR-1.515.916 ist eine spiralförmige Heizvorrichtung offenbart, die unter dem Tiegel einer Vorrichtung zum Ziehen eines Halbleiterkristalls angeordnet ist.

In der EP-628 645 A1 ist ein den Tiegel umgebender Spiralheizer beschrieben, der ein Magnetfeld erzeugt und die zum Ziehen eines Siliciumkristalls benötigte Wärme bereitstellt.

Die US-5,162,072 betrifft eine Vorrichtung zur Herstellung eines Kristalls nach der Czochralski-Methode. Zur Kontrolle von Strömungen in der Schmelze wird unter dem Tiegel ein Heizer angeordnet, der eine Vielzahl individuell kontrollierbarer Heizelemente umfaßt.

Die Erfindung löst die Aufgabe, das Aufschmelzen von Silicium in einem Quarzglas-Tiegel zu verkürzen, den Tiegel vor einer Überhitzung zu schützen und die Schmelze zu stabilisieren.

Gegenstand der Erfindung ist ein Verfahren zur Herstellung eines Silicium-Einkristalls durch Aufschmelzen von Silicium in einem Quarzglas-Tiegel und Ziehen des Einkristalls aus einer Silicium-Schmelze, das dadurch gekennzeichnet ist, daß Energie mit Hilfe einer unter dem Tiegel angeordneten, spiralförmigen Heizvorrichtung zumindest zeitweise induktiv in die Schmelze eingekoppelt wird.

Gegenstand der Erfindung ist ferner eine Heizvorrichtung zum Beheizen eines mit Silicium gefüllten Quarzglas-Tiegels, die unterhalb des Tiegels angeordnet ist, wobei die Heizvorrichtung in Form einer gewundenen Spirale ausgebildet ist und Stromzuführungen aufweist, die für den Betrieb von Wechselstrom und Gleichstrom ausgelegt sind.

Das Verfahren zeichnet sich insbesondere dadurch aus, daß nicht nur Heizenergie direkt in die Siliciumschmelze übertragen wird, sondern diese durch die Feld induzierte Schmelzenkonvektion auch schnell und homogen in der Schmelze verteilt wird. Wegen des wesentlich höheren elektrischen Widerstandes der übrigen Ofenkomponenten (Graphit) erfolgt die Energieeinkoppelung überwiegend in der Schmelze. Die Art der Übertragung der Heizenergie und die beschriebenen Folgen verkürzen die zum Aufschmelzen des Silicium benötigte Zeit erheblich. Darüber hinaus wird der Tiegel durch den in den Tiegelinnenraum gerichteten Wärmetransport vor einer Überhitzung durch die ihn seitlich umgebende Widerstandsheizvorrichtung bewahrt. Während des Ziehens des Einkristalls kann die durch induktive Beheizung erzwungene Konvektion in der Schmelze eingesetzt werden, um unkontrollierte, lokale Fluktationen der Temperatur und der Konzentration von Dotierstoffen und Verunreinigungen zu reduzieren und die Schmelze zu stabilisieren. Dies begünstigt wiederum das Ziehen eines versetzungsfreien und homogen dotierten Einkristalls.

Da Silicium nur in flüssigem Zustand mit dem induzierten elektromagnetischen Feld in die gewünschte Wechselwirkung tritt, wird zu Beginn des Verfahrens festes Silicium mit Hilfe einer Widerstandsheizvorrichtung geschmolzen. Neben einer konventionellen, um den Tiegel herum angeordneten Heizvorrichtung kann dafür auch eine Heizvorrichtung gemäß der Erfindung, die nachfolgend Bodenheizer genannt wird, herangezogen werden. Der Bodenheizer wird an eine Gleichstromquelle angeschlossen und als Widerstandsheizung betrieben. Zum Aufschmelzen des Hauptteils des Siliciums wird der Bodenheizer jedoch auf Wechselstrombetrieb umgeschaltet, so daß die Energieübertragung auf das Silicium induktiv erfolgt. Es wird vorzugsweise eine sinusförmige Wechselspannung, eine mit Gleichspannungsanteilen modulierte Wechselspannung oder eine durch wiederholtes Umschalten erzeugte Wechselspannung angelegt. Die Frequenz der Wechselspannung beträgt vorzugsweise 20 Hz bis 10 kHz. Bei höheren Frequenzen der Wechselspannung wird die Schmelze lokal stärker erhitzt, als bei niedrigeren Frequenzen. Andererseits reicht die Energie-Einkopplung bei niedrigeren Frequenzen weiter in den Tiegelinnenraum hinein. Es empfiehlt sich daher, während des Aufschmelzens des Siliciums anfänglich mit höheren Frequenzen zu arbeiten, um Silicium möglichst rasch zu schmelzen, und später auf einen Betrieb mit niedrigeren Frequenzen zu wechseln, um die Schmelze zu stabilisieren. Während des Ziehens des Einkristalls kann der Bodenheizer entweder mit Gleichstrom in der Funktion einer üblichen Widerstandsheizung oder zur weiteren Stabilisierung der Schmelze mit Wechselstrom oder mit moduliertem Gleichstrom betrieben werden.

Wird die Heizvorrichtung mit moduliertem Gleichstrom betrieben, kann auch der Sauerstoffgehalt der Schmelze gesteuert werden. Der Sauerstoffgehalt wird insbesondere durch die Geschwindigkeit der Konvektionsbewegung der Schmelze beeinflußt. Der Wechselstromanteil des modulierten Stroms bestimmt die in die Schmelze eingekoppelte Leistung und damit den Konvektionsantrieb, während mit dem Gleichstromanteil die erforderliche Gesamtwärmeleistung der Heizvorrichtung geregelt wird. Die Konvektionsgeschwindigkeit kann deshalb durch Verändern der Modulationsamplitude unabhängig vom gesamten Wärmehaushalt gesteuert werden.

Eine andere Möglichkeit, den Sauerstoffgehalt in der Schmelze zu steuern, besteht darin, eine relativ starke Modulationsamplitude zu wählen und dadurch eine hohe Konvektionsgeschwindigkeit einzustellen und diese durch ein äußeres, statisches Magnetfeld, das die Schmelze durchdringt, gezielt abzubremsen.

Eine weitere Möglichkeit der Beeinflussung des Sauerstoffgehalts der Schmelze bietet sich durch eine Variation der Frequenz des Wechselstromanteils, da die Frequenzänderung die Eindringtiefe des elektromagnetischen Felds und damit die Konvektion verändert.

Einzelheiten zur Vorrichtung werden nachfolgend an Hand von Figuren näher beschrieben. Es sind nur solche Merkmale dargestellt, die zum besseren Verständnis der Erfindung notwendig sind. Figur 1 zeigt schematisch einen Längsschnitt durch eine Vorrichtung zum Ziehen eines Einkristalls nach der Czochralski-Methode mit einer erfindungsgemäßen Heizvorrichtung. Die Figuren 2 bis 4 sind Detaildarstellungen zu bevorzugten Ausbildungsmerkmalen der Heizvorrichtung. In Figur 5 ist eine besonders bevorzugte Ausführungsform der Heizvorrichtung dargestellt. In den Figuren sind gleichartige Merkmale mit gleichen Bezugszahlen versehen.

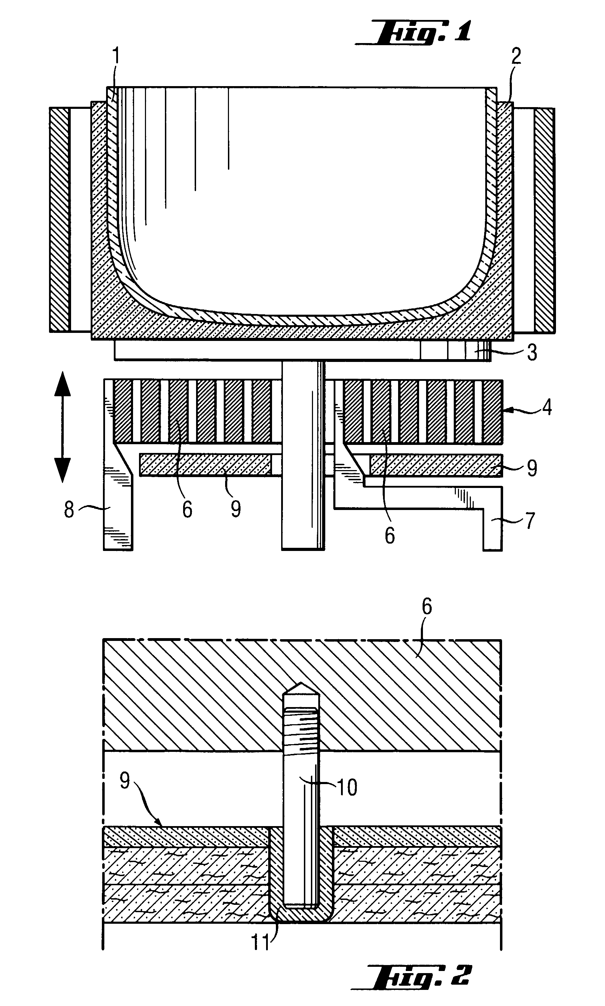

Zunächst wird auf die Figur 1 Bezug genommen. Dargestellt sind ein Tiegel 1 aus Quarzglas, der in einem Stütztiegel 2 eingebettet ist und zusammen mit diesem auf einem Stützteller 3 einer drehbaren und axial verschiebbaren Welle abgestützt ist. Der Tiegel 1 ist seitlich von einer zylinderförmigen Widerstands-Heizvorrichtung umgeben. Ein erfindungsgemäßer Bodenheizer 4 ist unterhalb des Tiegels angeordnet. Radiale Schlitze (in der Figur nicht dargestellt) reduzieren eine unerwünschte induktive Einkopplung in den Stütztiegel 2. Entsprechend sind auch andere, dem Bodenheizer benachbarte Vorrichtungsteile vorzugsweise radial geschlitzt. Der Bodenheizer 4 besteht im wesentlichen aus einer Spirale, die vorzugsweise aus Graphit, CFC (carbon fibre composite) oder Metallen wie Molybdän oder Tantal gefertigt ist. Die Windungen 6 der Spirale führen in sich weitenden Bahnen von einer inneren Stromzuführung 7 zu einer äußeren Stromzuführung 8. Die Anzahl der Windungen richtet sich nach dem Spiralenmaterial, wobei Spiralen aus Kohlenstoff wegen des höheren spezifischen elektrischen Widerstands dieses Materials weniger Windungen aufweisen, als Metall-Spiralen gleichen Durchmessers. Die Windungen der Spirale können in einer oder in mehreren, übereinanderliegenden Lagen angeordnet sein. Unterhalb des Bodenheizers befindet sich eine thermisch isolierende Bodenplatte 9. Es ist bevorzugt, jede der Windungen der Spirale auf der Bodenplatte an mindestens drei Stützstellen mechanisch zu fixieren, beispielsweise mit Hilfe von Stützelementen, die an den Windungen angebracht und elektrisch isoliert oder aus elektrisch isolierendem Material sind. Die Stützelemente halten zugleich die Windungen der Spirale auf konstantem Abstand zueinander und dämpfen mögliche Vibrationen der Windungen. Die Bodenplatte ist vorzugsweise aus Graphit gefertigt und dient zweckmäßigerweise gleichzeitig als Stromzuführung für die innere Elektrode des Bodenheizers.

Als Stützelement kann beispielsweise ein in Figur 2 dargestellter Steg 10 dienen, der mit einer Windung 6 verbunden ist und wie ein Fuß von dieser absteht. In der dargestellten Ausführungsform besteht die Bodenplatte 9 aus einem Verbund einer Graphitplatte und darunter liegender Graphitfilzplatten. Der Steg 10 steckt in einer Hülse 11, die vorzugsweise aus Quarzglas gefertigt ist. Die Hülse ist in einer entsprechenden Bohrung in der Bodenplatte eingebettet.

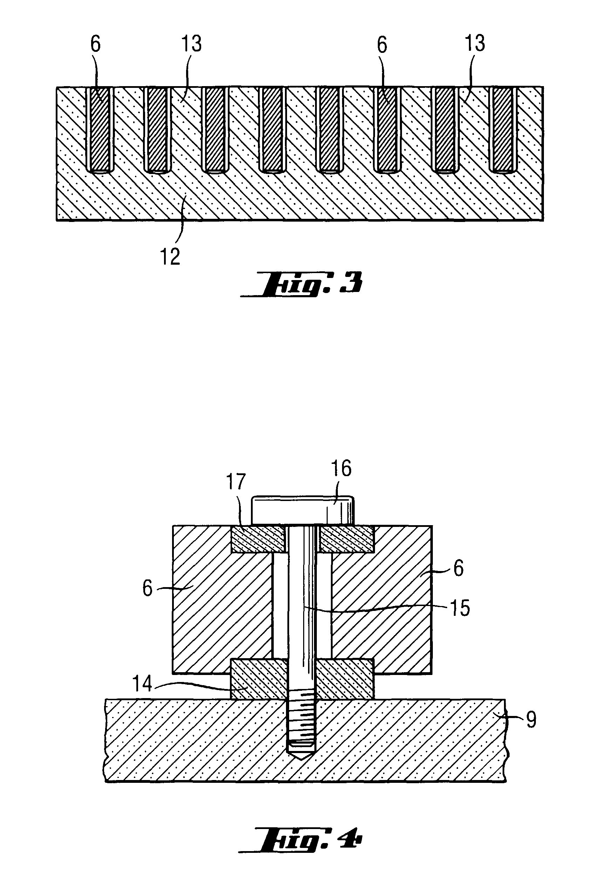

Figur 3 zeigt ein weiteres Beispiel, wie die Windungen der Spirale auf einer Bodenplatte abgestützt werden können. Als Stützelement fungiert hier ein kammförmiger, elektrisch isolierender Abstandshalter 12, der vorzugsweise aus Bornitrid besteht und auf einer Bodenplatte aufliegt (nicht dargestellt). Der Abstandshalter besitzt auf einer Seite Zinken 13, die in die Zwischenräume zwischen den Windungen 6 geschoben sind.

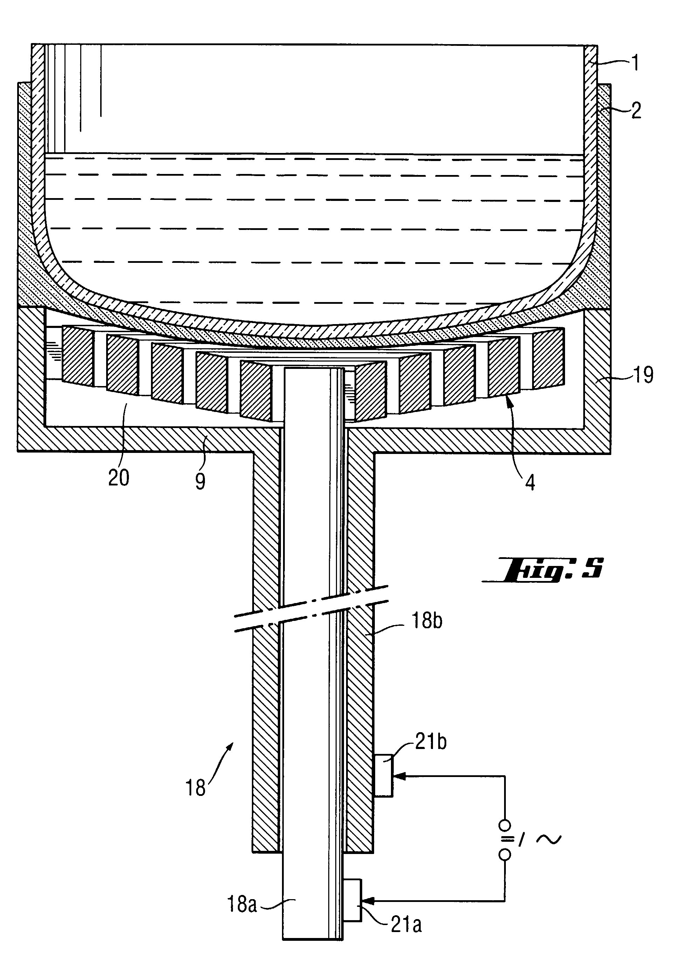

Ein weiteres Beispiel zur Ausgestaltung der Abstützung der Windungen ist in Figur 4 dargestellt. Als Stützelement wird ein ringförmiger, elektrisch isolierender Abstandshalter 14 vorgeschlagen, der zwei benachbarte Windungen 6 abstützt und durch eine Schraube 15 mit einer Bodenplatte 9 verschraubt ist. Der Kopf 16 der Schraube fixiert die Windungen über einen isolierenden Ring 17 auf dem Abstandshalter. Die Schraube ist vorzugsweise aus CFC gefertigt. Der Abstandshalter und der Ring bestehen vorzugsweise aus Bornitrid. Eine andere, ähnliche Möglichkeit (nicht dargestellt) der Abstützung einer Windung kann dadurch erfolgen, daß die Windung von einem ringförmigen, elektrisch isolierenden Abstandshalter auf der Bodenplatte abgestützt wird. In diesem Fall ist es zweckmäßig, die Windung mit der Bodenplatte zu verbinden, beispielsweise indem eine elektrisch isolierte oder aus elektrisch isolierendem Material gefertigte Schraube durch die Bodenplatte und den Abstandshalter hindurch in die Windung geschraubt wird. Ist die Bodenplatte aus elektrisch isolierendem Material, z. B. Bornitrid, gefertigt, können die Windungen direkt mit CFC-Schrauben an der Bodenplatte befestigt werden.

Während des Ziehens eines Einkristalls ist es üblich, den Tiegel mit Hilfe der Welle anzuheben, um die Oberfläche der Schmelze trotz des abnehmenden Schmelzenvolumens auf konstantem Niveau zu halten. Da der Betrag der Energieeinkopplung vom Abstand zwischen Bodenheizer und Tiegel abhängig ist, ist es bevorzugt, den Bodenheizer der axialen Tiegelbewegung nachzuführen und seinen Abstand zum Tiegel ebenfalls konstant zu halten. Grundsätzlich kann dafür eine separate Mechanik bereitgestellt werden, die den Bodenheizer synchron mit dem Tiegel bewegt. In einer bevorzugten Ausführungsform werden axiale Bewegungen des Tiegels und des Bodenheizers mit Hilfe einer besonders ausgebildeten Welle 18 ausgeführt (Figur 5). Die Welle 18 ist in zwei koaxial zueinander liegende Teile 18a und 18b geteilt, wobei der innen liegende Teil als innere Stromzuführung des Bodenheizers 4 ausgebildet ist. Der außen liegende Teil dient zusammen mit einer Bodenplatte 9 und einem Rohr 19 als äußere Stromzuführung für den Bodenheizer und stützt zugleich die Bodenplatte 9 ab. Die Bodenplatte formt zusammen mit dem Rohr 19 und einem Stütztiegel 2 einen Hohlraum 20 aus, in dem sich der Bodenheizer 4 befindet. Der Bodenheizer ist im Hohlraum praktisch eingeschlossen, so daß von ihm ausgehende Verunreinigungen nicht über die Gasphase in die Schmelze gelangen können. Der Anschluß der Stromzuführungen an eine Stromquelle erfolgt über Schleifringe 21a und 21b.

## Patentansprüche

1. Verfahren zur Herstellung eines Silicium-Einkristalls durch Aufschmelzen von Silicium in einem Quarzglas-Tiegel und Ziehen des Einkristalls aus einer Silicium-Schmelze, dadurch gekennzeichnet, daß Energie mit Hilfe einer unter dem Tiegel angeordneten, spiralförmigen Heizvorrichtung zumindest zeitweise induktiv in die Schmelze eingekoppelt wird.

2. Verfahren nach Anspruch 1, dadurch gekennzeichnet, daß die Heizvorrichtung während des Aufschmelzens von Silicium zumindest zeitweise mit Wechselstrom betrieben wird.

3. Verfahren nach Anspruch 2, dadurch gekennzeichnet, daß die Frequenz des Wechselstroms verändert wird.

4. Verfahren nach Anspruch 1, dadurch gekennzeichnet, daß die Heizvorrichtung während des Aufschmelzens von Silicium zumindest zeitweise mit moduliertem Gleichstrom betrieben wird.

5. Verfahren nach Anspruch 1, dadurch gekennzeichnet, daß die Heizvorrichtung während des Ziehens des Einkristalls mit Gleichstrom betrieben wird.

6. Verfahren nach Anspruch 1, dadurch gekennzeichnet, daß die Heizvorrichtung während des Ziehens des Einkristalls mit Wechselstrom betrieben wird.

7. Verfahren nach Anspruch 1, dadurch gekennzeichnet, daß die Heizvorrichtung während des Ziehens des Einkristalls mit moduliertem Gleichstrom betrieben wird, und das Verhältnis von Wechselstromanteil und Gleichstromanteil geändert wird.

8. Verfahren nach Anspruch 1, dadurch gekennzeichnet, daß die Heizvorrichtung während des Ziehens des Einkristalls mit moduliertem Gleichstom betrieben wird, und ein statisches Magnetfeld, das die Schmelze durchdringt, erzeugt wird.

9. Verfahren nach Anspruch 1, dadurch gekennzeichnet, daß die Heizvorrichtung während des Ziehens des Einkristalls mit moduliertem Gleichstom betrieben wird, und die Frequenz des Wechselstromanteils geändert wird.

10. Kristallzüchtungsapparat mit einer Heizvorrichtung zum Beheizen eines mit Silicium gefüllten Tiegels, die unterhalb des Tiegels angeordnet und in der Form einer gewundenen Spirale ausgebildet ist, dadurch gekennzeichnet, daß die Spirale zum Zweck des induktiven Einkoppelns von Energie in die Schmelze vertikal verschiebbar ausgebildet ist.

11. Kristallzüchtungsapparat nach Anspruch 10, dadurch gekennzeichnet, daß die Windungen der Spirale über Stege auf einer Bodenplatte mechanisch fixiert sind.

12. Kristallzüchtungsapparat nach Anspruch 10, dadurch gekennzeichnet, daß die Windungen der Spirale über einen kammartig zwischen sie eingreifenden, Abstandshalter aus elektrisch isolierendem Material auf einer Bodenplatte mechanisch fixiert sind.

13. Kristallzüchtungsapparat nach Anspruch 10, dadurch gekennzeichnet, daß die Windungen der Spirale über ringförmige Abstandshalter aus elektrisch isolierendem Material auf einer Bodenplatte mechanisch fixiert sind.

14. Kristallzüchtungsapparat nach Anspruch 10, dadurch gekennzeichnet, daß die Windungen der Spirale direkt auf einer Bodenplatte aus elektrisch isolierendem Material befestigt sind.

15. Kristallzüchtungsapparat nach einem der Ansprüche 12 bis 14, dadurch gekennzeichnet, daß das elektrisch isolierende Material Bornitrid ist.

16. Kristallzüchtungsapparat nach einem der Ansprüche 10 bis 15, dadurch gekennzeichnet, daß die Spirale in einem Hohlraum untergebracht ist.

## Claims

1. Process for producing a silicon single crystal by melting silicon in a quartz-glass crucible and pulling the single crystal from a silicon melt, characterized in that energy is delivered to the melt at least some of the time inductively using a coiled heater arranged under the crucible.

2. Process according to Claim 1, characterized in that the heater is operated at least some of the time with alternating current during the melting of the silicon.

3. Process according to Claim 2, characterized in that the frequency of the alternating current is varied.

4. Process according to Claim 1, characterized in that the heater is operated at least some of the time with modulated direct current during the melting of the silicon.

5. Process according to Claim 1, characterized in that the heater is operated with direct current during the pulling of the single crystal.

6. Process according to Claim 1, characterized in that the heater is operated with alternating current during the pulling of the single crystal.

7. Process according to Claim 1, characterized in that the heater is operated with modulated direct current during the pulling of the single crystal, and the ratio between the AC component and the DC component is varied.

8. Process according to Claim 1, characterized in that the heater is operated with modulated direct current during the pulling of the single crystal, and a static magnetic field which penetrates the melt is produced.

9. Process according to Claim 1, characterized in that the heater is operated with modulated direct current during the pulling of the single crystal, and the frequency of the AC component is varied.

10. Crystal-growing device having a heater, intended for heating a silicon-filled crucible and arranged below the crucible and designed in the shape of a wound coil, characterized in that the coil for the purpose of inductively coupling energy into the melt is designed to be vertically displacable.

11. Crystal-growing device according to Claim 10, characterized in that the turns of the coil are mechanically fixed to a base plate via bridging elements.

12. Crystal-growing device according to Claim 10, characterized in that turns of the coil are mechanically fixed to a base plate via a spacer which is made of electrically insulating material and engages between them in comb fashion.

13. Crystal-growing device according to Claim 10, characterized in that the turns of the coil are mechanically fixed to a base plate via annular spacers made of insulating material.

14. Crystal-growing device according to Claim 10, characterized in that the turns of the coil are fastened directly to a base plate made of electrically insulating material.

15. Crystal-growing device according to one of Claims 12 to 14, characterized in that the electrically insulating material is boron nitride.

16. Crystal-growing device according to one of Claims 10 to 15, characterized in that the coil is placed in a cavity.

## Revendications

1. Procédé de préparation d'un monocristal de silicium par fusion du silicium dans un creuset en verre quartzeux et par étirage du monocristal sur du temporairement silicium fondu, caractérisé par le fait que l'énergie est injectée dans la matière fondue au moins de manière inductive temporairement à l'aide d'un dispositif de chauffage hélicoïdal disposé sous le creuset.

2. Procédé selon la revendication 1, caractérisé par le fait que le dispositif de chauffage est alimenté en courant alternatif au moins temporairement pendant la fusion du silicium.

3. Procédé selon la revendication 2, caractérisé par le fait que la fréquence du courant alternatif varie.

4. Procédé selon la revendication 1, caractérisé par le fait que le dispositif de chauffage est alimenté en courant continu modulé au moins temporairement pendant la fusion du silicium.

5. Procédé selon la revendication 1, caractérisé par le fait que le dispositif de chauffage est alimenté en courant continu pendant l'étirage du monocristal.

6. Procédé selon la revendication 1, caractérisé par le fait que le dispositif de chauffage est alimenté en courant alternatif pendant l'étirage du monocristal.

7. Procédé selon la revendication 1, caractérisé par le fait que le dispositif de chauffage est alimenté en courant continu modulé pendant l'étirage du monocristal et que le rapport entre la composante continue et la composante alternative varie.

8. Procédé selon la revendication 1, caractérisé par le fait que le dispositif de chauffage est alimenté en courant continu modulé pendant l'étirage du monocristal et qu'il se produit un champ magnétique statique qui pénètre dans la masse fondue.

9. Procédé selon la revendication 1, caractérisé par le fait que le dispositif de chauffage est alimenté en courant continu modulé pendant l'étirage du monocristal et que la fréquence de la composante alternative varie.

10. Appareil de façonnage des cristaux muni d'un dispositif de chauffage pour chauffer un creuset rempli de silicium, lequel est disposé sous le creuset et se présente sous la forme d'une spirale, caractérisé par le fait que la spirale est coulissante dans le sens vertical afin de pouvoir faire pénétrer de manière inductive l'énergie dans la masse fondue.

11. Appareil de façonnage des cristaux selon la revendication 10, caractérisé par le fait que les enroulements de la spirale sont fixés mécaniquement sur une plaque de fond par des traverses.

12. Appareil de façonnage des cristaux selon la revendication 10, caractérisé par le fait que les enroulements de la spirale sont fixés mécaniquement sur une plaque de fond par des pièces d'écartement en matériau isolant électrique en forme de peigne et qui pénètrent entre lesdits enroulements.

13. Appareil de façonnage des cristaux selon la revendication 10, caractérisé par le fait que les enroulements de la spirale sont fixés mécaniquement sur une plaque de fond par des pièces d'écartement de forme annulaire en matériau isolant électrique.

14. Appareil de façonnage des cristaux selon la revendication 10, caractérisé par le fait que les enroulements de la spirale sont fixés directement sur une plaque de fond en matériau isolant électrique.

15. Appareil de façonnage des cristaux selon l'une des revendications 12 à 14, caractérisé par le fait que le matériau isolant électrique est du nitrure de bore.

16. Appareil de façonnage des cristaux selon l'une des revendications 10 à 15, caractérisé par le fait que la spirale est logée dans un espace creux.
